# FASCICULE DE BREVET EUROPEEN

(11) **EP 1 508 901 B1**
(45) Date de publication et mention de la délivrance du brevet: **15.08.2007**
(21) Numéro de dépôt: 04291653.6
(22) Date de dépôt: 30.06.2004
(51) Int. Cl.: G11C 16/22

(54) **Circuit mémoire à mémoire non volatile d'identification et procédé associé**
Speicherschaltung mit nichtflüchtigem Identifikationsspeicher und zugehöriges Verfahren
Memory circuit having nonvolatile identification memory and associated process

(30) Priorité: 18.08.2003 FR 0309987
(43) Date de publication de la demande: 23.02.2005
(73) Titulaire: STMicroelectronics S.A., 92120 Montrouge (FR)
(72) Inventeur: Devin, Jean, 13100 Le Tholonet (FR)
(74) Mandataire: Bentz, Jean-Paul

(56) Documents cités:
- EP-A- 1 143 455
- DE-A- 4 340 027
- US-A- 5 553 019

## Description

L'invention concerne les circuits mémoires comprenant une zone de mémoire non volatile d'inscription de codes d'identification.

Le document US5 553 019 décrit un système mémoire à écriture unique et lecture multiple pour protéger électroniquement une partie de sélection d'une mémoire contre un effacement. Le système mémoire inclut des cellules de stockage pour le stockage électronique d'informations. Une cellule de contrôle est utilisé pour contrôler l'accès en écriture et/ou en effacement aux cellules de stockage. Une logique de contrôle est prévue pour contrôler l'accès à la cellule de contrôle.

Le document DE 43 40 027 décrit un procédé de protection en écriture de la mémoire d'un dispositif de commande électronique. Une zone de mémoire protégée de la mémoire est prévue. Un bit de la zone de mémoire protégée est utilisé comme drapeau de protection en écriture. L'accès à la zone de mémoire protégée dépendra de l'état de ce drapeau.

Des mémoires non volatiles présentant une zone mémoire de stockage d'un code d'identification sont connues. La zone mémoire est typiquement programmée à la fin d'un test de la mémoire pour l'identifier de façon unique ou pour mémoriser des données de fabrication. Cette zone mémoire est typiquement programmable par une broche de programmation. Le circuit de la mémoire non volatile est conçu pour ne transmettre qu'une unique commande de programmation à la zone mémoire, de sorte que le code stocké n'est normalement pas modifié.

Une telle mémoire et son procédé de fonctionnement présentent des inconvénients. En effet, la zone mémoire de stockage de code d'identification peut frauduleusement être reprogrammée relativement facilement.

Il existe donc un besoin pour un circuit mémoire ou un procédé qui résolve un ou plusieurs de ces inconvénients.

L'invention a ainsi pour objet un circuit mémoire, comprenant :
- une zone mémoire utile;
- une zone mémoire non volatile de stockage d'au moins un code d'identification;
- une broche de fixation d'état de la zone mémoire de stockage de code d'identification;
- un registre dont l'état ne peut être fixé qu'une unique fois, stockant un état indiquant si l'état de la zone mémoire de stockage de code d'identification a été fixé;
- un module bloquant la fixation d'état de la zone mémoire de stockage de code d'identification lorsque le registre indique que l'état de la zone mémoire de stockage de code d'identification a été fixé.

Le registre est programmable une unique fois et est constitué d'un transistor à grille flottante dont le la grille ou le drain et la source ne sont pas alimentés par une tension d'effacement.

Selon une variante, la broche est une broche de programmation, le registre est programmable une unique fois, l'état du registre indique si la zone mémoire de stockage de code d'identification est programmée, le module bloque la programmation de la zone mémoire de stockage lorsque le registre indique que la zone mémoire est programmée.

Selon une variante, la zone mémoire utile est non volatile.

Selon encore une variante, la zone mémoire utile, la zone de stockage de code d'identification et le registre sont des cellules de mémoire EEPROM.

On peut également prévoir que le circuit comprend en outre un circuit logique ET, dont deux entrées sont connectées respectivement au registre et à la broche de fixation d'état, et dont là sortie est connectée à une borne de fixation d'état de la zone mémoire de stockage de code d'identification.

L'invention a également pour objet un procédé selon la revendication 6.

Selon une variante, le registre est programmable une unique fois, le marqueur inscrit est un marqueur d'état programmé.

Selon une autre variante, le procédé comprend en outre une étape de test de la zone mémoire utile préalable à l'inscription du code d'identification.

L'invention sera mieux comprise à partir de la figure annexée, fournie à titre d'exemple, et qui représente une représentation schématique d'un exemple de circuit mémoire selon l'invention.

L'invention propose d'utiliser un registre dont l'état ne peut être fixé qu'une unique fois pour mémoriser la fixation d'état de la zone mémoire de code d'identification et bloquer d'ultérieures tentatives de fixation d'état.

L'invention va être décrite par la suite dans le cas le plus général de la fixation d'état. Le texte placé entre parenthèse correspond au cas particulier illustré où la fixation d'état comprend la programmation sélective de cellules mémoires. Selon une alternative, la fixation d'état utilisée peut bien entendu être un effacement sélectif de cellules mémoires.

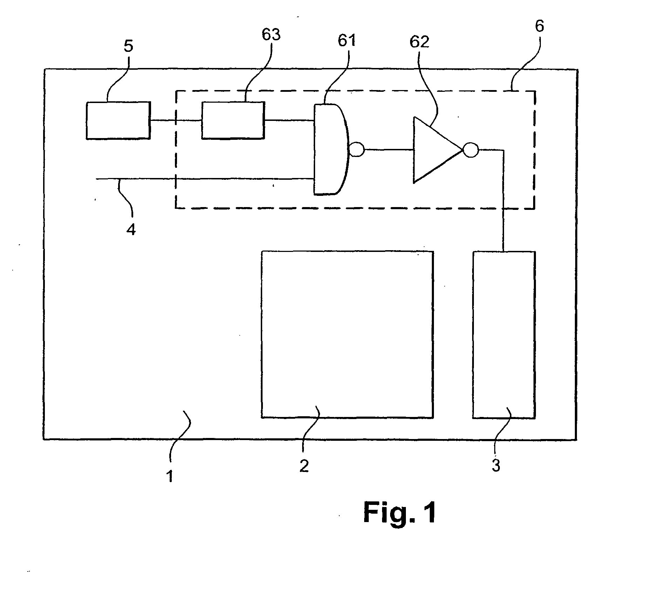

La figure 1 représente schématiquement un exemple de circuit mémoire 1 selon l'invention. le circuit mémoire 1 comprend une zone mémoire utile 2 destinée au stockage des données utiles. Le circuit mémoire 1 comprend également une zone mémoire non volatile de stockage d'au moins un code d'identification 3.

Le code d'identification peut par exemple être un code inscrit après une étape de test du circuit mémoire 1, à la fin du processus de fabrication. Ce code d'identification peut notamment être un code identifiant de façon unique le circuit, un code identifiant les conditions de production du circuit ou un code utilisable pour des opérations de cryptage des données utiles du circuit mémoire.

Le circuit mémoire 1 comprend également une broche de fixation d'état 4 (en l'occurrence une broche de programmation) de la zone mémoire de stockage de code d'identification 3. Cette broche 4 est prévue pour permettre au moins une étape de fixation d'état (en l'occurrence une étape de programmation) de la zone mémoire de stockage 3.

Le circuit mémoire 1 comprend en outre un registre dont l'état ne peut être fixé qu'une unique fois 5 (programmable une unique fois), stockant un état indiquant si l'état de la zone mémoire de stockage de code d'identification 3 a été fixé (cet état indique si la zone mémoire 3 a été programmée). Le registre présente typiquement un état correspondant à une zone mémoire 3 dont l'état n'a pas été fixé (la zone mémoire 3 n'a pas été programmée) et un autre état correspondant à une zone mémoire 3 dont l'état a été fixé (la zone mémoire 3 a été programmée). Une taille de 1 bit peut ainsi être suffisante pour mémoriser si l'état de la zone mémoire 3 a été fixé.

Le circuit mémoire 1 comprend en outre un module 6 bloquant la fixation d'état (en l'occurrence la programmation) de la zone mémoire 3 lorsque le registre 5 indique que l'état de cette zone mémoire 3 a été fixé (en l'occurrence lorsque cette zone mémoire 3 a été programmée)

Une fois que l'état de la zone mémoire 3 a été fixé (lorsque la zone mémoire a été programmée), le registre 5 l'est également. Du fait que le l'état du registre 5 ne peut être fixé (programmé) qu'une seule fois, toute tentative de fixation d'état (programmation) ultérieure de la zone mémoire 3 est bloquée. Une tentative erronée ou frauduleuse de fixation d'état (programmation) de la zone mémoire 3 est alors efficacement évitée.

L'invention s'applique avantageusement à un circuit mémoire dans lequel la zone mémoire utile 2 est non volatile. La zone mémoire 3 protégée permet alors de certifier le contenu de la zone mémoire utile 2. La zone mémoire 2 peut notamment être constituée de mémoire EEPROM, de mémoire Flash ou de mémoire ferro-électrique.

Avantageusement, la zone mémoire utile 2, la zone mémoire de stockage 3 et le registre programmable 5 sont des cellules d'une mémoire EEPROM ou d'une mémoire Flash. Il s'avère en effet relativement aisé de réaliser ces différentes zones mémoires dans les cellules d'une unique mémoire d'un tel type. En effet, à partir de légères modifications de masques utilisés pour la réalisation de telles mémoires, on peut obtenir un circuit mémoire 1 selon l'invention.

Le registre programmable est constitué d'un transistor à grille flottante dont le drain et la source ne présentent pas les connexions permettant de recevoir des tensions d'effacement. On peut ainsi prévoir que la source et le drain soient uniquement connectés à une source de tension de programmation et de lecture. Dans l'exemple d'une mémoire Flash, on peut prévoir que le drain, le substrat et la source ne soient pas connectés à une pompe d'extraction des électrons de la grille flottante. Le registre programmable 5 peut aussi être constitué d'un transistor à grille flottante dont la grille ne présente pas les connexions permettant de recevoir une tension d'effacement. Le transistor peut alors être programmé mais ne peut être effacé pour être reprogrammé. Pour une fixation d'état par effacement, l'homme de métier saura également prévoir des connexions adéquates du transistor à grille flottante pour empêcher sa programmation. Ces modes de réalisations sont particulièrement adaptés à la variante dans laquelle les différentes zones mémoires sont des cellules mémoire EEPROM ou Flash : de simples modifications de masques de fabrication permettent de supprimer des connexions entre une électrode d'un transistor à grille flottante et une pompe de charge. Ces modes de réalisation sont particulièrement avantageux car il est extrêmement difficile de modifier frauduleusement un tel circuit mémoire pour alimenter les électrodes des transistors et permettre le cas échéant leur programmation ou leur effacement.

Plus généralement, il suffit de réaliser des connexions des électrodes d'un transistor à grille flottante telles qu'il soit possible :
- soit d'ajouter mais pas de retrancher des électrons de la grille flottante;
- soit de retrancher mais pas d'ajouter des électrons dans la grille flotte.

Selon une variante préférée, le module de blocage 6 est réalisé de la façon suivante: le module 6 comprend un circuit logique ET, dont deux entrées sont connectées respectivement au registre 5 et à la broche 4. La sortie du circuit ET est connectée à une borne de programmation de la zone mémoire 3. On réduit avantageusement un circuit ET présentant un nombre de transistors réduit en plaçant en série une porte logique NON-ET 61 et un circuit NON 62, comme illustré à la figure 1.

Dans le circuit mémoire 1, représenté, un circuit de lecture du registre 5 est interposé entre le registre 5 et le circuit ET.

Dans l'exemple représenté, on peut prévoir que le circuit 63 fournisse un signal logique à 1 lorsque le registre 5 est vierge, ce qui correspond à une zone mémoire 3 non programmée. Ainsi, lorsqu'une requête de fixation d'état (programmation) est appliquée sur la broche 4, elle est validée par le circuit ET. Après la fixation d'état (programmation) de la zone mémoire 3, l'état du registre 5 a également été fixé (le registre est programmé). Le circuit 63 fournit alors un signal logique à 0. Ainsi, lorsqu'une requête fixation d'état (programmation) est appliquée sur la broche 4, elle est invalidée par le circuit ET.

Le procédé d'utilisation du circuit mémoire 1 peut ainsi être le suivant:

On inscrit un code d'identification dans la zone mémoire d'identification, puis on inscrit un marqueur d'état fixé (programmé) dans le registre 4, puis on bloque la fixation d'état (programmation) de la zone mémoire d'identification.

L'inscription du code d'identification peut être précédée d'une étape de test de la zone mémoire utile, par exemple à la fin du processus de fabrication de la mémoire. Le code d'identification peut alors contenir des données provenant du résultat des tests.

L'invention n'est bien entendu pas limitée aux exemples et modes de réalisation décrits et représentés, mais est susceptible de nombreuses variantes accessibles à l'homme de l'art.

## Revendications

1. Circuit mémoire (1), comprenant :
- une zone mémoire utile (2);
- une zone mémoire non volatile de stockage (3) d'au moins un code d'identification;
- une broche de fixation d'état (4) de la zone mémoire de stockage de code d'identification;
- un registre (5) dont l'état ne peut être fixé qu'une unique fois, stockant un état indiquant si l'état de la zone mémoire de stockage de code d'identification a été fixé;
- un module (6) bloquant la fixation d'état de la zone mémoire de stockage de code d'identification lorsque le registre (5) indique que l'état de la zone mémoire de stockage de code d'identification a été fixé ;
- **caractérisé en ce que** le registre (5) est programmable une unique fois et est constitué d'un transistor à grille flottante dont le drain et la source ou la grille ne présentent pas de connexions permettant de recevoir une tension d'effacement, de façon que le transistor peut être programmé mais ne peut pas être effacé pour être reprogrammé.

2. Circuit selon la revendication 1, **caractérisé en ce que** :
- la broche (4) est une broche de programmation;
- l'état du registre indique si la zone mémoire de stockage de code d'identification est programmée;
- le module bloque la programmation de la zone mémoire de stockage lorsque le registre indique que la zone mémoire est programmée.

3. Circuit selon la revendication 1 ou 2, **caractérisé en ce que** la zone mémoire utile (2) est non volatile.

4. Circuit selon la revendication 3, **caractérisé en ce que** la zone mémoire utile (2), la zone de stockage de code d'identification (3) et le registre (5) sont des cellules de mémoire EEPROM.

5. Circuit selon l'une quelconque des revendications précédentes, **caractérisé en ce qu'**il comprend en outre un circuit logique ET (61), dont deux entrées sont connectées respectivement au registre et à la broche de fixation d'état, et dont la sortie est connectée à une borne de fixation d'état de la zone mémoire de stockage de code d'identification (3).

6. Procédé d'utilisation d'un circuit mémoire (1) selon la revendication 1, comprenant les étapes de:
- inscription d'un code d'identification dans la zone mémoire d'identification;
- inscription d'un marqueur d'état fixé dans le registre;
- blocage de la fixation d'état de la zone mémoire d'identification.

7. Procédé selon la revendication 6, **caractérisé en ce que** :
- le marqueur inscrit est un marqueur d'état programmé.

8. Procédé selon la revendication 6 ou 7, **caractérisé en ce qu'**il comprend en outre une étape de test de la zone mémoire utile préalable à l'inscription du code d'identification.

## Claims

1. Memory circuit (1) comprising:
- a useful memory area (2);
- a non-volatile storage memory area (3) for storing at least one identification code;
- a pin (4) for fixing the state of the identification code storage memory area;
- a register (5) for which the state can only be fixed once, storing a state indicating whether or not the state of the identification code storage memory area has been fixed;
- a module (6) making it impossible to fix the state of the identification code storage memory area when the register (5) indicates that the state of the identification code storage memory area has been fixed, **characterized in that** the register (5) can be programmed once only and is composed of a floating grid transistor the drain and the source or the grid of which do not have connections through which an erase voltage could be applied to them, so that the transistor can be programmed but cannot be erased to be reprogrammed.

2. Circuit according to claim 1, **characterized in that**:
- the pin (4) is a programming pin;
- the state of the register indicates if the identification code storage memory area is programmed;
- the module blocks programming of the storage memory area when the register indicates that the memory area is programmed.

3. Circuit according to either claim 1 or 2, **characterized in that** the useful memory area (2) is non-volatile.

4. Circuit according to claim 3, **characterized in that** the useful memory area (2), the identification code storage area (3) and the register (5) are EEPROM memory cells.

5. Circuit according to any one of the above claims, **characterized in that** it is also fitted with an AND logic circuit (61), in which there are two inputs, one connected to the register and the other to the state fixation pin, and the output of which is connected to a terminal for fixing the state of the identification code storage memory area (3).

6. Method for using a memory circuit (1) according to claim 1, comprising the following steps:
- entering an identification code in the identification memory area;
- entering a fixed state marker in the register;
- blocking the fixed state of the identification memory area.

7. Method according to claim 6, **characterized in that**:
- the entered marker is a programmed state marker.

8. Method according to either claim 6 or 7, **characterized in that** it also includes a step to test the useful memory area before entering the identification code.

## Patentansprüche

1. Speicherschaltung (1), mit:
- einem freien Speicherbereich (2);
- einem nicht flüchtigen Speicherbereich (3) zur Speicherung wenigstens eines Identifikationscodes;
- einem Zustand-Fixierstift (4) des Speicherbereiches zur Speicherung des Identifikationscodes;
- einem Register (5), dessen Zustand nur ein einziges Mal fixiert werden kann, das einen Zustand speichert, der angibt, ob der Zustand des Speicherbereichs für die Speicherung des Identifikationscodes fixiert worden ist;
- ein Modul (6), das die Fixierung des Zustands des Speicherbereichs für die Speicherung des Identifikationscodes blockiert, wenn das Register (5) anzeigt, dass der Zustand des Speicherbereichs für die Speicherung des Identifikationscodes fixiert worden ist;
- **dadurch gekennzeichnet, dass** das Register (5) ein einziges Mal programmierbar ist und aus einem Floating-Gate-Transistor gebildet wird, dessen Drain-Elektrode und Source-Elektrode oder Gate keine Anschlüsse aufweisen, die ihm ermöglichen, eine Löschspannung zu empfangen, derart, dass der Transistor programmiert werden kann, aber nicht für eine Neuprogrammierung gelöscht werden kann.

2. Schaltung nach Anspruch 1, **dadurch gekennzeichnet, dass**:
- der Stift (4) ein Programmierstift ist;
- der Zustand des Registers anzeigt, ob der Speicherbereich zur Speicherung des Identifikationscodes programmiert ist;
- das Modul die Programmierung des Speicherbereichs für die Speicherung blockiert, wenn das Register anzeigt, dass der Speicherbereich programmiert ist.

3. Schaltung nach Anspruch 1 oder 2, **dadurch gekennzeichnet, dass** der freie Speicherbereich (2) nicht flüchtig ist.

4. Schaltung nach Anspruch 3, **dadurch gekennzeichnet, dass** der freie Speicherbereich (2), der Speicherbereich für den Identifikationscode (3) und das Register (5) EEPROM Speicherzellen sind.

5. Schaltung nach einem der vorstehenden Ansprüche, **dadurch gekennzeichnet, dass** diese ferner einen UND-Logikschaltkreis (61) umfasst, dessen zwei Eingänge jeweils an das Register und an den Zustand-Fixierstift angeschlossen sind und dessen Ausgang an eine Zustand-Fixierklemme des Speicherbereichs für die Speicherung des Identifikationscodes (3) angeschlossen ist.

6. Anwendungsverfahren für eine Speicherschaltung (1) nach Anspruch 1, mit den Schritten:
- Schreiben eines Identifikationscodes in den Speicherbereich für die Identifizierung;
- Schreiben eines festgelegten Zustandsmarkierers in das Register;
- Blockieren der Zustandsfixierung des Speicherbereichs für die Identifizierung.

7. Verfahren nach Anspruch 6, **dadurch gekennzeichnet, dass**:
- der festgehaltene Markierer ein programmierter Zustandsmarkierer ist.

8. Verfahren nach Anspruch 6 oder 7, **dadurch gekennzeichnet, dass** dieses ferner einen Testschritt für den freien Speicherbereich vor dem Einschreiben des Identifikationscodes umfasst.
